# EUROPÄISCHE PATENTSCHRIFT

(11) **EP 3 942 698 B1**
(45) Veröffentlichungstag und Bekanntmachung des Hinweises auf die Patenterteilung: **31.07.2024**
(21) Anmeldenummer: 20707567.2
(22) Anmeldetag: 27.02.2020
(51) Int. Cl.: H03K 19/003, H03K 19/0175

(54) **SCHALTVORRICHTUNG UND SYSTEM MIT SCHALTVORRICHTUNG ZUM WANDELN EINES DIFFERENTIELLEN EINGANGSSIGNALS**
SWITCHING DEVICE AND SYSTEM WITH A SWITCHING DEVICE FOR THE CONVERSION OF A DIFFERENTIAL INPUT SIGNAL
DISPOSITIF DE COMMUTATION ET SYSTÈME AVEC DISPOSITIF DE COMMUTATION POUR CONVERTIR UN SIGNAL D'ENTRÉE DIFFÉRENTIEL

(30) Priorität: 22.03.2019 DE 102019002044
(43) Veröffentlichungstag der Anmeldung: 26.01.2022
(73) Patentinhaber: SEW-EURODRIVE GmbH & Co. KG, 76646 Bruchsal (DE)
(72) Erfinder: NORENBURG, Benjamin, 76689 Karlsdorf-Neuthard (DE); SENFT, Christian, 76228 Karlsruhe-Grünwettersbach (DE); RICHTER, Sebastian, 69120 Heidelberg (DE); KOLLAR, Hans Jürgen, 76646 Bruchsal (DE); MADER, Marco, 76646 Bruchsal (DE)
(86) Internationale Anmeldenummer: PCT/EP2020/025099
(87) Internationale Veröffentlichungsnummer: WO 2020/192965

(56) Entgegenhaltungen:
- DE-A1- 102013 106 739
- FR-A1- 2 776 443
- US-A1- 2019 068 088

## Beschreibung

Die Erfindung betrifft eine Schaltvorrichtung und ein System zum Wandeln eines differentiellen Eingangssignals.

**Aus** US 2010 / 0 327 914 A1 **ist eine Schaltvorrichtung zum Wandeln eines differentiellen Eingangssignals zu einem massebezogenen Ausgangssignal bekannt.**

**Aus** US 2008 / 0 025 451 A1 **ist ein weiterer Stand der Technik bekannt. Aus der** US 2019/068088 A1 **ist als nächstliegender Stand der Technik eine Schaltvorrichtung bekannt, die ein differentielles Eingangssignal in ein massebezogenes Ausgangssignal wandelt.**

**Aus der** DE 10 2013 106739 A1 **ist eine Sicherheitsschalteinrichtung mit fehlersicheren Eingängen bekannt.**

**Aus der** FR 2 776 443 A1 **ist eine galvanisch entkoppelte bidrektionale Busschnittstelle bekannt.**

Aufgabe der vorliegenden Erfindung ist die Weiterentwicklung von elektronischen Schaltungsvorrichtungen.

Erfindungsgemäß wird die Aufgabe mit einer Schaltvorrichtung nach den in Anspruch 1 und nach einem System mit Schaltvorrichtung nach den in Anspruch 13 angegebenen Merkmalen gelöst.

Wichtige Merkmale der Erfindung zum Wandeln eines differentiellen Eingangssignals zu einem massebezogenen Ausgangssignal mit einem Steuersignal, sind, dass Fehlerzustände, insbesondere die durch Fehler bei der Pegelwandlung und/oder der Signallaufzeit entstehen, erkannt werden, wobei erkannte Fehlerzustände zum Abschalten des massebezogenen Signals führen und zusätzlich auf dem Steuersignal angezeigt werden.

Erfindungsgemäß umfasst die Schaltvorrichtung eine Differenzstufe und eine Ausgangsstufe, wobei die Differenzstufe in Abhängigkeit des differentiellen Eingangssignals, um eine erste Signallaufzeit t1 verzögert, ein erstes massebezogenes Signal erzeugt, und wobei die Ausgangsstufe das massebezogene Ausgangssignal in Abhängigkeit des ersten massebezogenen Signals und des Steuersignals erzeugt,
**wobei** die Schaltvorrichtung eine weitere Differenzstufe, eine Auswertestufe und eine bidirektionale Kommunikationsstufe umfasst, wobei die weitere Differenzstufe in Abhängigkeit des differentielle Eingangssignals, um eine zweite Signallaufzeit t2 verzögert, ein zweites massebezogenes Signal erzeugt, insbesondere wobei die zweite Signallaufzeit t2 sehr viel kleiner als die erste Signallaufzeit t1 ist, wobei die Auswertestufe in Abhängigkeit des ersten massebezogenen Signals und des zweiten massebezogenen Signals und unter Berücksichtigung der ersten Signallaufzeiten t1 und der zweiten Signallaufzeit t2 ein drittes massebezogenes Signal erzeugt, wobei die bidirektionale Kommunikationsstufe das Steuersignal **entweder** in Abhängigkeit des dritten massebezogenen Signals **oder** in Abhängigkeit des dritten massebezogenen Signals **und** zumindest einer Gegenstelle erzeugt, wobei die Ausgangsstufe das erste massebezogene Signal zusätzlich in Abhängigkeit des dritten massebezogenen Signals an das massebezogene Ausgangssignal weiterleitet. Unter Gegenstelle ist hierbei eine Komponente zu verstehen, die mit der Schaltvorrichtung in Verbindung steht und mit der Schaltvorrichtung Informationen austauscht.

Erfindungsgemäß ist sowohl die zweite Signallaufzeit t2 als auch das zweite massebezogene Signal als Referenz verwendbar, um Fehler der Differenzstufe erkennen und mitteilen zu können, und eine weitere Abschaltmöglichkeit für das massebezogene Ausgangssignal verfügbar wird.

**Vorteilhafterweise ist bei gleichbleibender Anzahl der Schnittstellensignale ein definierter Zustand des massebezogenen Ausgangsignals herstellbar und eine zeitoptimierte Fehlerbehebung gewährbar.**

Erfindungsgemäß ist **während des Betriebs erkennbar, ob die Information des Ausgangssignals stets der Information auf dem Eingangssignal entspricht.**

**Außerdem werden bei der vorliegenden Erfindung Fehlerzustände, die durch Fehler bei der Pegelwandlung und/oder der Signallaufzeit entstehen, erkannt, wobei erkannte Fehlerzustände zum Abschalten des Ausgangssignals führen und zusätzlich auf dem Pin des Steuersignals angezeigt werden.**

**Der Erfindung hat also zum Vorteil, bei gleichbleibender Anzahl der Schnittstellensignale einen definierten Zustand des Ausgangssignals herzustellen und eine zeitoptimierte Fehlerbehebung zu ermöglichen.**

Bei einer weiteren vorteilhaften Ausgestaltung realisiert die Differenzstufe den Massebezug mittels eines Optokopplers. Das Ausgangssignal des Optokopplers wird über ein Filterelement geführt. Ein erstes Schaltelement leitet in Abhängigkeit des Ausgangssignals des Filterelements eine Versorgungsspannung an das erste massebezogene Signal weiter. Die erste Signallaufzeit t1 der Differenzstufe setzt sich aus der Summe der Schaltzeiten des Optokopplers und des ersten Schaltelements und der Verzögerungszeit des Filterelements zusammen.

Vorteilhafterweise wird damit eine galvanische Trennung zwischen dem differentiellen Eingangssignal und dem ersten massebezogenen Signal gewährleistet, Störimpulse und/oder Transienten, d.h. meist kurzzeitige Signalpegeländerungen im differentiellen Eingangssignal, die entweder absichtlich, beispielsweise zum Testen einer elektronischen Schaltung, oder unabsichtlich, beispielsweise durch eine Störeinstrahlung, auf das eigentliche Nutzsignal eingekoppelt werden, unterdrückt und das erste massebezogene Signal zum Führen höherer Ströme, insbesondere zum Versorgen weiterer Schaltungsteile, befähigt.

Bei einer weiteren vorteilhaften Ausgestaltung realisiert die weitere Differenzstufe das zweite massebezogene Signal mittels eines weiteren Optokopplers. Die zweite Signallaufzeit t2 der weiteren Differenzstufe entspricht dabei größtenteils der Schaltzeit des weiteren Optokopplers.

Vorteilhafterweise wird damit eine galvanische Trennung zwischen dem differentiellen Eingangssignal und dem zweiten massebezogenen Signal gewährleistet.

Bei einer weiteren vorteilhaften Ausgestaltung wertet die Auswertestufe das erste massebezogene Signal und das zweite massebezogene Signal über zumindest ein erstes Logikgatter, insbesondere über ein XOR-Logikgatter, aus. Das Ausgangssignal des ersten Logikgatters wird über ein weiteres Filterelement geführt. Das weitere Filterelement weist eine Verzögerungszeit tf auf. Die Verzögerungszeit tf wird in Abhängigkeit von der ersten Signallaufzeit t1, von der zweiten Signallaufzeit t2 und von einem Signallaufzeittoleranzwert td gewählt, insbesondere wobei die Verzögerungszeit tf = |t2 - t1| + td entspricht. Vorteilhafterweise ist damit eine Abweichung des ersten massebezogenen Signals gegenüber dem zweiten massebezogenen Signal bezüglich Signallaufzeit und Signalpegel feststellbar.

Bei einer weiteren vorteilhaften Ausgestaltung umfasst das weitere Filterelement ein RC-Filter und ein zweites Logikgatter, insbesondere ein invertierendes Logikgatter. Die Nennwerte des RC-Filters werden mit tf = R * C gewählt. Das zweite Logikgatter digitalisiert das Ausgangssignal des RC-Filters und erzeugt das Ausgangssignal des weiteren Filterelements. Insbesondere ist dabei das zweite Logikgatter in CMOS-Technologie ausgeführt.

Vorteilhafterweise ist damit das Einstellen der Verzögerungszeit tf kostengünstig und platzsparend möglich.

Bei einer weiteren vorteilhaften Ausgestaltung entspricht das Ausgangssignal des weiteren Filterelements dem dritten massebezogenen Signal.

Bei einer weiteren vorteilhaften Ausgestaltung setzt das Ausgangssignal des weiteren Filterelements ein Speicherelement, insbesondere ein RS-FlipFlop. Das Ausgangssignal eines dritten Logikgatters, insbesondere eines WIRED-OR-Logikgatters, setzt das Speicherelement zurück. Das dritte Logikgatter wertet das erste massebezogene Signal und das zweite massebezogene Signal aus. Das Ausgangssignal des Speicherelements entspricht dem dritten massebezogenen Signal. Vorteilhafterweise ist damit ein erkannter Fehlerzustand solange speicherbar bis sowohl der Pegel des ersten massebezogenen Signals als auch der Pegel des zweiten massebezogenen Signals auf Massepotential liegen.

Bei einer weiteren vorteilhaften Ausgestaltung umfasst die bidirektionale Kommunikationsstufe eine Kommunikationsschnittstelle, insbesondere eine Open-Drain-Schnittstelle, mit einem Pull-Up-Widerstand zur Versorgungsspannung **oder zu einer weiteren Versorgungsspannung.**

Das Steuersignal kann über ein zweites Schaltelement in Abhängigkeit des dritten massebezogenen Signals, insbesondere invertierend, nach Massepotential kurzgeschlossen werden. Vorteilhafterweise kann damit eine Schnittstelle ausgebildet werden, die über nur ein einziges Signal einen Informationsfluss in beide Richtungen ermöglicht.

Bei einer weiteren vorteilhaften Ausgestaltung umfasst die Ausgangsstufe ein viertes Schaltelement und zumindest ein viertes Logikgatter. Das vierte Schaltelement leitet dabei das erste massebezogene Signal in Abhängigkeit des dritten massebezogenen Signals an zumindest einen Versorgungsspannungseingang des vierten Logikgatters weiter. Das vierte Logikgatter erzeugt das massebezogene Ausgangssignal in Abhängigkeit des Signals am Versorgungsspannungseingang und des Steuersignals. Vorteilhafterweise ist somit eine diversitär-redundante Abschaltung des massebezogenen Ausgangssignals realisierbar, wobei unter diversitär-redundanter Abschaltung eine gleichberechtigte mehrstufige Abschaltung mit unterschiedlichen Funktionsprinzipen zu verstehen ist, die sowohl in Abhängigkeit des Versorgungsspannungseingangs des vierten Logikgatters als auch in Abhängigkeit des Steuersignals am Signaleingang des vierten Logikgatters das massebezogene Ausgangssignal in einen definierten Zustand versetzen kann.

Bei einer weiteren vorteilhaften Ausgestaltung wird das Ausgangssignal des Filterelements der Differenzstufe zusätzlich als ein viertes massebezogenes Signal an die Ausgangsstufe weitergeleitet. Das vierte Logikgatter der Ausgangsstufe ist dabei als AND-Logikgatter mit invertierenden Eingängen oder als NOR-Logikgatter ausgeführt und erzeugt das massebezogene Ausgangssignal zusätzlich in Abhängigkeit des vierten massebezogenen Signals. Vorteilhafterweise kann damit, insbesondere ohne die Verzögerungszeiten des ersten und vierten Schaltelements, das massebezogene Ausgangssignal laufzeitoptimiert schnell abgeschaltet werden.

Bei einer weiteren vorteilhaften Ausgestaltung werden Fehlerzustände, die aus Fehlern auf einer weiteren Versorgungsspannung entstehen, erkannt.

Vorteilhafterweise wird damit eine zusätzliche Fehlerdiagnose zur Verfügung gestellt.

Bei einer weiteren vorteilhaften Ausgestaltung umfasst die Schaltvorrichtung eine Versorgungsspannungsschutzstufe, die in Abhängigkeit des Signalpegels der weiteren Versorgungsspannung die Versorgungsspannung erzeugt. Der Spannungspegel der weiteren Versorgungsspannung wird dabei überwacht, wobei ein Spannungspegel innerhalb eines gültigen Bereichs, insbesondere innerhalb von +3 VDC bis +3,5 VDC, zu einer Weiterleitung der weiteren Versorgungsspannung an die Versorgungsspannung und ein Spannungspegel außerhalb des gültigen Bereichs zu einer Trennung zwischen der weiteren Versorgungsspannung und der Versorgungsspannung führt. Vorteilhafterweise ist die Schaltvorrichtung damit vor Störungen, die über die Versorgungsspannung in das System eingebracht werden, schützbar.

Bei einer weiteren vorteilhaften Ausgestaltung weist ein System mit der Schaltvorrichtung eine Sicherheits-gerichtete Schaltvorrichtung und einen Frequenzumrichter auf. Dabei ist das differentielle Eingangssignal (S_DIFF_IN) von der Sicherheits-gerichteten Schaltvorrichtung erzeugbar. Das Steuersignal (S_EXT) ist vom Frequenzumrichter auswert- und ansteuerbar. Das massebezogene Ausgangssignal (S_OUT) ist zur Unterbrechung einer Drehfeld-Erzeugung des Frequenzumrichters verwendbar.

Bei einer weiteren vorteilhaften Ausgestaltung ist das Steuersignal (S_EXT) über zumindest ein drittes Schaltelement im Frequenzumrichter nach Massepotential (GND) kurzschließbar. Bei einer weiteren vorteilhaften Ausgestaltung ist über das massebezogene Ausgangssignal (S_OUT) ein Bustreiber-Baustein zur Übertragung von PWM-Signalen für die Drehfelderzeugung des Frequenzumrichters mit Spannung versorgbar.

Weitere Vorteile ergeben sich aus den Unteransprüchen.

Die Erfindung wird nun anhand von Abbildungen näher erläutert:

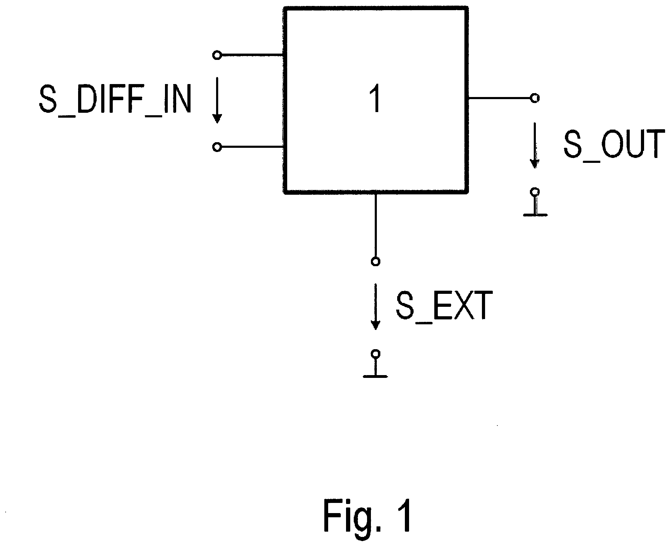

In der Figur 1 sind die externen Schnittstellen der Schaltvorrichtung (1) abgebildet. Dabei weist die Schaltvorrichtung (1) erfindungsgemäß drei externe Schnittstellen auf. Das differentielle Eingangssignal (S_DIFF_IN) wird aufgenommen, gewandelt und in Abhängigkeit des Steuersignals (S_EXT) als massebezogenes Ausgangssignal (S_OUT) ausgegeben. Das differentielle Eingangssignal (S_DIFF_IN) ist hierbei ein Signal, das symmetrisch, d.h. mit einem Paar gleichartiger Signalleiter, übertragen wird.

Typischerweise wird auf dem ersten Signalleiter ein Informationssignal und auf dem zweiten Signalleiter ein statisches Referenzsignal oder ein zum ersten Signalleiter identisches aber invertiertes Signal als Referenz, übertragen. Vorzugsweise liegt die Differenzspannung des differentiellen Eingangssignals (S_DIFF_IN) dabei innerhalb eines Spannungsbereichs von - 30 V DC bis +60 V DC, insbesondere wobei die Schaltvorrichtung befähigt ist einen differentiellen Signalpegel von kleiner +5 V DC als LOW-Pegel und einen differentiellen Signalpegel von größer +11 V DC als HIGH-Pegel zu interpretieren und in Abhängigkeit dieser interpretierten Pegelzustände und in Abhängigkeit des Steuersignals (S_EXT) das massebezogene Ausgangssignal (S_OUT) zu setzen.

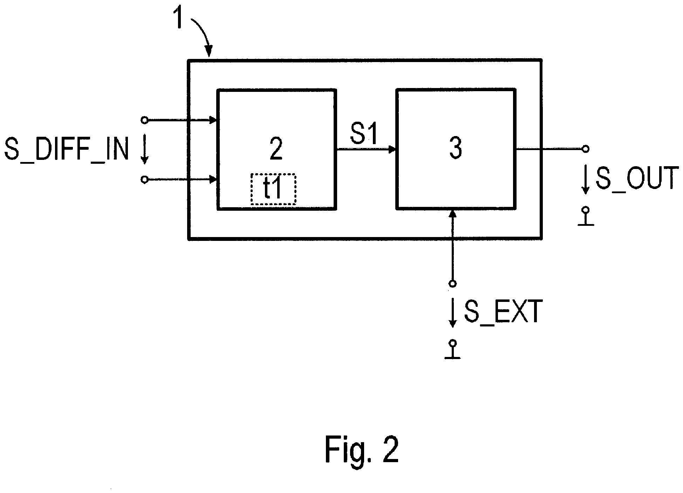

In der Figur 2 ist eine mögliche Realisierung der Schaltvorrichtung (1) nach dem Stand der Technik gezeigt. Die Schaltvorrichtung wird weiter verfeinert, indem diese in eine Differenzstufe (2) und eine Ausgangsstufe (3) aufgeteilt wird.

Die Differenzstufe (2) erzeugt aus dem differentiellen Eingangssignal (S_DIFF_IN) das erste massebezogene Signal (S1). Die erste Signallaufzeit t1, also die Zeit, die eine Zustandsänderung auf dem differentiellen Eingangssignal (S_DIFF_IN) benötigt bis diese auf dem ersten massebezogenen Signal (S1) angezeigt wird, ergibt sich dabei aus dem internen Aufbau der Differenzstufe (2).

Die Ausgangsstufe (3) stellt das massebezogene Ausgangssignal (S_OUT) am Ausgang für eine weitere Verwendung innerhalb eines Systems zur Verfügung. Dabei entscheidet der Zustand des Steuersignals (S_EXT), ob der Pegel des ersten massebezogenen Signals (S1) auf dem massebezogenen Ausgangssignal (S_OUT) abgebildet oder das massebezogene Ausgangssignal (S_OUT) in einen definierten Zustand, typischerweise auf Massepotential (GND), gezogen wird.

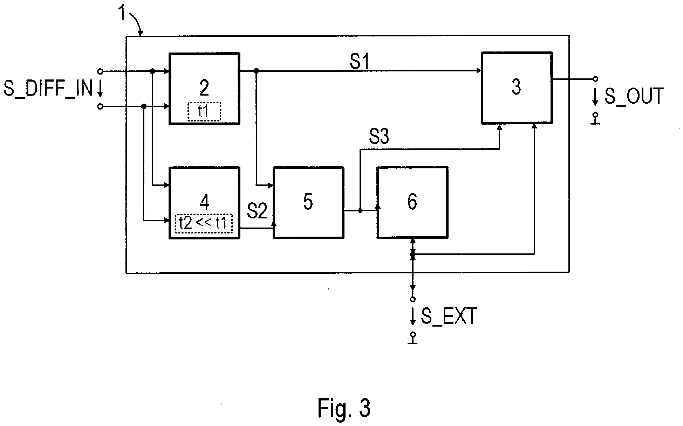

In der Figur 3 ist eine erfindungsgemäße Schaltvorrichtung (1) dargestellt. Die Schaltvorrichtung (1) wird weiter verfeinert, indem zusätzlich zur Differenzstufe (2) und der Ausgangsstufe (3) eine weitere Differenzstufe (4), eine Auswertestufe (5) und eine bidirektionale Kommunikationsstufe (6) eingefügt werden.

Die weitere Differenzstufe (4) erzeugt aus dem differentiellen Eingangssignal (S_DIFF_IN) das zweite massebezogene Signal (S2). Die zweite Signallaufzeit t2, also die Zeit, die eine Zustandsänderung auf dem differentiellen Eingangssignal (S DIFF_IN) benötigt bis diese auf dem zweiten massebezogenen Signal (S2) angezeigt wird, ergibt sich dabei aus dem internen Aufbau der weiteren Differenzstufe (2). Der interne Aufbau der weiteren Differenzstufe (2) ist insbesondere so gewählt, dass sich eine zweite Signallaufzeit t2 ergibt, die sehr viel kleiner als die erste Signallaufzeit t1 der Differenzstufe (2) ist.

Die Auswerteeinheit (5) vergleicht das erste massebezogene Signal (S1) mit dem zweiten massebezogenen Signal (S2) und erzeugt in Abhängigkeit des Ergebnisses dieses Vergleichs das dritte massebezogene Signal (S3).

Damit wird ein Test realisiert, der die Funktionsfähigkeit der Differenzstufe (2) überwacht und bei einer Abweichung gegenüber dem Signalverhalten der weiteren Differenzstufe (4) als Referenz und unter Berücksichtigung der ersten Signallaufzeit t1 und der zweiten Signallaufzeit t2 diese Information innerhalb der Schaltvorrichtung (1) weiteren Funktionsblöcken zur Verfügung stellt.

Die bidirektionale Kommunikationsstufe (6) weist im Gegensatz zum Stand der Technik eine Schnittstelle für das Steuersignal (S_EXT) auf, die sowohl eine Steuerinformation an die Schaltvorrichtung (1) als auch eine Meldeinformation von der Schaltvorrichtung (1) verarbeiten kann.

Die Ausgangsstufe (3) verwendet zusätzlich zum Stand der Technik das dritte massebezogene Signal (S3). Dabei entscheidet der Zustand des dritten massebezogenen Signals (S3) und des Steuersignals (S_EXT), ob der Pegel des ersten massebezogenen Signals (S1) auf dem massebezogenen Ausgangssignal (S_OUT) abgebildet oder das massebezogene Ausgangssignal (S_OUT) in einen definierten Zustand, meist auf Massepotential (GND), gezogen wird.

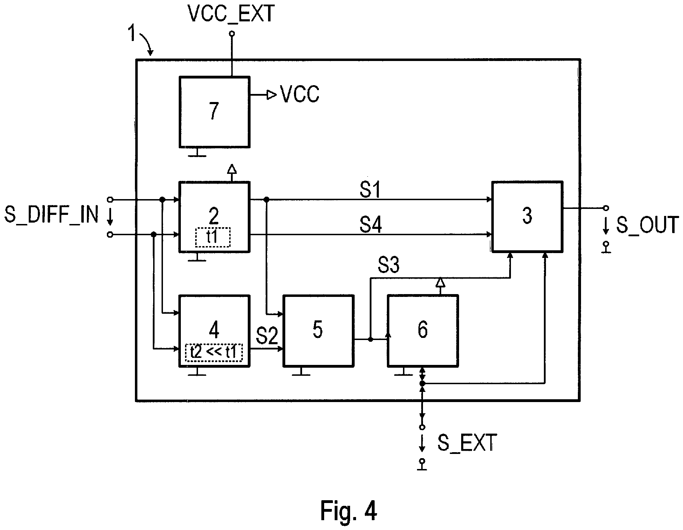

In der Figur 4 ist ein weiteres Ausführungsbeispiel einer erfindungsgemäßen Schaltvorrichtung (1) wiedergegeben. Zusätzlich zur Figur 3 umfasst die Figur 4 eine Versorgungsspannungs-schutzstufe (7) und ein viertes massebezogenes Signal (S4).

Die Versorgungsspannungsschutzstufe (7) ist dem Eingang der Versorgungsspannung (VCC) vorgeschaltet und überwacht dabei die eigentliche Versorgungsspannung zum Betreiben der Schaltvorrichtung (1), hier als weitere Versorgungsspannung (VCC_EXT) bezeichnet, auf einen gültigen Spannungsbereich hin. Spannungspegel der weiteren Versorgungsspannung (VCC_EXT) innerhalb des gültigen Spannungsbereichs führen dazu, dass die weitere Versorgungsspannung (VCC_EXT) auf die Versorgungsspannung (VCC) weitergeleitet wird. Spannungspegel der weiteren Versorgungsspannung (VCC_EXT) außerhalb des gültigen Spannungsbereichs führen dazu, dass die weitere Versorgungsspannung (VCC_EXT) von der Versorgungsspannung (VCC) getrennt wird und sich somit auf der Versorgungsspannung (VCC) ein spannungsfreier Zustand einstellt.

Der spannungsfreie Zustand bewirkt, dass sich sowohl das massebezogene Ausgangssignal (S_OUT) als auch das Steuersignal (S_EXT) auf oder zumindest nahe dem Massepotential (GND) befinden. Darüber hinaus wird in der Differenzstufe (2) das vierte massebezogene Signal (S4) erzeugt, das von der Ausgangsstufe (3) zusätzlich ausgewertet wird.

Dabei entscheidet der Zustand des dritten massebezogenen Signals, der Zustand des vierten massebezogenen Signals (S4) und der Zustand des Steuersignals (S_EXT), ob der Pegel des ersten massebezogenen Signals (S1) auf dem massebezogenen Ausgangssignal (S_OUT) abgebildet oder das massebezogene Signal (S_OUT) in einen definierten Zustand, typischerweise auf Massepotential (GND), gezogen wird. Insbesondere ist die Versorgungsspannungsschutzstufe (7) so dimensioniert, dass am Eingang zur Aufnahme der weiteren Versorgungsspannung (VCC_EXT) Versorgungsspannungspegel zumindest im Bereich von -0,5 V DC bis +15 V DC anlegbar sind.

Ferner ist die Erzeugung und Auswertung des vierten massebezogenen Signals (S4) derart gestaltet, dass eine laufzeitoptimierte Schnellabschaltung des massebezogenen Ausgangssignals (S_OUT) ermöglicht wird.

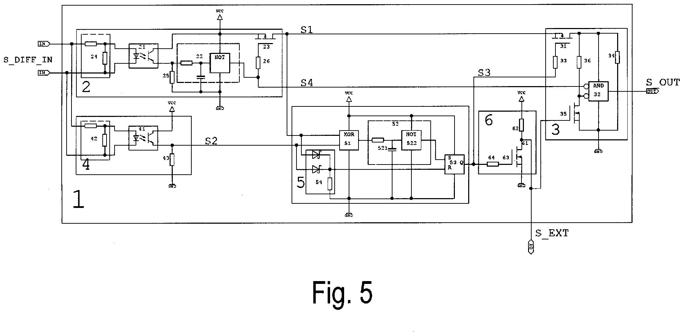

In der Figur 5 ist eine beispielhafte Implementierung der erfindungsgemäßen Schaltvorrichtung (1) beschrieben. Dabei werden ausgehend von Figur 4 die Funktionsblöcke Differenzstufe (2), Ausgangsstufe (3), weitere Differenzstufe (4), Auswertestufe (5) und bidirektionale Kommunikationsstufe (6) weiter verfeinert und eine mögliche schaltungstechnische Realisierung aufgezeigt.

In der Differenzstufe (2) wird dabei das differentielle Eingangssignal (S_DIFF_IN) mittels eines Optokopplers (21) ausgewertet. Der Eingang des Optokopplers (21) ist mit einem Widerstandsspannungsteiler (24) beschaltet. Am Ausgang schaltet der Optokoppler (21) die Versorgungsspannung (VCC) gegen einen Pull-Down Widerstand (25). Das Ausgangssignal des Optokopplers (21) wird dabei über ein Filterelement (22), bestehend aus einem RC-Filter und einem invertierenden Logikgatter, insbesondere einem invertierenden Logikgatter mit einem Schmitt-Trigger-Eingang, geführt.

Das Ausgangssignal des invertierenden Logikgatters bildet hierbei gleichzeitig das Ausgangssignal des Filterelements (22) und wird als viertes massebezogenes Signal (S4) einem nachgelagerten Funktionsblock zur Verfügung gestellt. Zusätzlich wird das Ausgangssignal des Filterelements (22) auch über einen Vorwiderstand (26) zur Ansteuerung des ersten Schaltelements (23), hier als PFET-Transistor ausgeführt, verwendet. Der PFET-Transistor ist hierbei befähigt, die Versorgungsspannung (VCC) über das erste massebezogene Signal (S1) mehreren nachgelagerten Funktionsblöcken weiterzuleiten.

In der weiteren Differenzstufe (4) wird das differentielle Eingangssignal (S_DIFF_IN) mittels eines weiteren Optokopplers (41) ausgewertet. Der Eingang des weiteren Optokopplers (41) wird über einen weiteren Widerstandsspannungsteiler (42) beschaltet. Am Ausgang schaltet der weitere Optokoppler (41) die Versorgungsspannung (VCC) gegen einen weiteren Pull-Down Widerstand (43) und das Ausgangssignal des weiteren Optokopplers (41) wird direkt als zweites massebezogenes Signal (S2) einem nachgelagerten Funktionsblock weitergeleitet.

Die Auswertestufe (5) vergleicht im Anschluss das erste massebezogene Signal (S1) mit dem zweiten massebezogenen Signal (S2) mittels eines ersten Logikgatters (51), hier als XOR-Logikgatter ausgeführt.

Der Ausgang des ersten Logikgatters (51) wird über ein weiteres Filterelement (52), bestehend aus einem RC-Filter (521) und einem zweiten Logikgatter (522), insbesondere einem zweiten invertierenden Logikgatter (522) mit einem Schmitt-Trigger-Eingang, geführt. Das Ausgangssignal des zweiten Logikgatters (522) bildet hierbei gleichzeitig das Ausgangssignal des weiteren Filterelements (52) und wird zum Ansteuern des Setz-Eingangs eines RS-Flipflops (53) verwendet. Zusätzlich wird sowohl das erste massebezogene Signal (S1) als auch das zweite massebezogene Signal (S2) über eine WIRED-OR-Schaltung (54), die aus je einer Diode im Signalpfad zum entsprechenden Signal hin besteht, logisch miteinander verknüpft und über einen Pull-Down-Widerstand mit Massepotential (GND) verbunden.

Das Ausgangssignal der WIRED-OR-Schaltung dient dabei zum Rücksetzen des RS-Flipflops (53). Das RS-FlipFlop (53) ist vorzugsweise so ausgeführt, dass dessen Eingänge LOW-aktiv sind. Eine derart gestaltete schaltungstechnische Ausführung erlaubt, dass unterschiedliche Spannungspegel zwischen dem ersten massebezogenen Signal (S1) und dem zweiten massebezogenen Signal (S2), die für eine Zeitdauer t größer als eine definierte Verzögerungszeit tf, die sich aus der Auswahl der Bauelemente des RC-Filters ergibt, anliegen, zu einem Setzen des RS-Flipflops führen und das RS-Flipflop (53) nur dann rücksetzbar ist, wenn sowohl auf dem ersten massebezogenen Signal (S1) als auch dem zweiten massebezogenen Signal (S2) ein Low-Pegel, d.h. ein Signalpegel nahe dem Massepegel (GND), anliegt.

Das Ausgangssignal des RS-Flipflops (53) bildet hierbei gleichzeitig das Ausgangssignal der Auswertestufe (5) und wird als drittes massebezogenes Signal (S3) weiteren nachgelagerten Funktionsblöcken zur Verfügung gestellt.

Die bidirektionale Kommunikationsstufe (6) verwendet im Anschluss das dritte massebezogene Signal (S3), um über einen Vorwiderstand (64) ein zweites Schaltelement (63), hier als NFET-Transistor ausgeführt, anzusteuern. Der NFET-Transistor bildet hier im Zusammenspiel mit einem zusätzlichen Pull-Up-Widerstand (62), der mit der Versorgungsspannung (VCC) verbunden ist, eine Kommunikationsschnittstelle (61), hier als Open-Drain-Schnittstelle ausgeführt, die in der Lage ist, das Steuersignal (S_EXT) in Abhängigkeit des dritten massebezogenen Signals (S3) auf Massepotential (GND) zu ziehen. Sowohl die bidirektionale Kommunikationsstufe (6) als auch eine optional daran angeschlossene Gegenstelle kann somit das Steuersignal (S_EXT) auf LOW-Pegel ziehen. Steuert weder die bidirektionale Kommunikationsstufe (6) noch die Gegenstelle das Signal (S_EXT) an, so stellt sich durch den Pull-Up-Widerstand (62) auf dem Signal (S_EXT) stets ein HIGH-Pegel ein.

Die Ausgangsstufe (3) verwendet ebenfalls das dritte massebezogen Signal (S3), um über einen Vorwiderstand (33) ein viertes Schaltelement (31), hier als PFET-Transistor ausgeführt, anzusteuern. Der PFET-Transistor ist hierbei in der Lage das erste massebezogene Signal (S1), und damit die Versorgungsspannung (VCC), auf den Versorgungsspannungseingang eines vierten Logikgatters (32), hier als AND-Logikgatter mit invertierenden Eingängen ausgeführt, weiterzuleiten. Gleichzeitig ist der Versorgungsspannungseingang des AND-Logikgatters über einen Pull-Down-Widerstand (34) mit dem Massepotential (GND) verbunden. Das Steuersignal (S_EXT) steuert hierbei ein fünftes Schaltelement (35), hier als NFET-Transistor ausgeführt, an. Dieser NFET-Transistor schaltet hierbei das Massepotential (GND) gegen einen Pull-Up-Widerstand (36), der sich ebenfalls auf den Versorgungsspannungs-eingang des AND-Logikgatters bezieht.

Mit Hilfe dieser Transistor-Schaltung wird der Spannungspegel auf dem Steuersignal (S_EXT) invertiert und mit einem der invertierenden Eingänge des AND-Logikgatters verbunden. Ein weiterer invertierender Eingang des AND-Logikgatters ist mit dem vierten massebezogenen Signal (S4) verbunden. Das Ausgangssignal des AND-Logikgatters bildet hierbei gleichzeitig das Ausgangssignal der Ausgangsstufe (3) und somit auch das massebezogene Ausgangssignal (S_OUT) der erfindungsgemäßen Schaltvorrichtung (1).

Mit diesem schaltungstechnischen Aufbau ermöglicht die Ausgangsstufe (3) eine schnelle Abschaltung des massebezogenen Ausgangssignals (S_OUT) bedingt durch das vierte massebezogene Signal (S4) und das Steuersignal (S_EXT) mittels dem vierten Logikgatter (32). Über das erste massebezogene Signal (S1) und das dritte massebezogene Signal (S3) wird zusätzlich eine diversitär redundante langsame Abschaltung des massebezogenen Ausgangssignals (S_OUT) bewirkt, bedingt durch die parasitären Restkapazitäten beim Abschalten der Versorgungsspannung, die zuerst entladen werden müssen. Mittels der Versorgungsspannungsabschaltung ist jedoch garantierbar, dass auch bei einem Ausfall des vierten Logikgatters (32) das massebezogene Ausgangssignal (S_OUT) abschaltbar ist.

**Das Steuersignal (S_EXT) ist insbesondere zur Steuerung der Ausgangsstufe (3) verwendbar.**

**Das erfindungsgemäße Steuersignal (S_EXT) wird sowohl von der bidirektionalen Kommunikationsstufe (6) als auch von einer optional an die Schaltvorrichtung (1) angeschlossenen Gegenstelle erzeugt.**

**In der beispielhaften Implementierung nach** **Figur 5** **bedeutet dabei ein HIGH-Pegel des Steuersignals (S_EXT) eine Freigabe der Ausgangsstufe (3) und ein LOW-Pegel des Steuersignals (S_EXT) eine Sperrung der Ausgangsstufe (3).**

**Dabei ist der LOW-Pegel dominant. Nur wenn die Kommunikationsstufe (6) und die Gegenstelle gemeinsam die Ausgangsstufe (3) freigeben, ergibt sich somit ein HIGH-Pegel auf dem Signal (S_EXT).**

**Möchte die Gegenstelle die Ausgangsstufe (3) freigeben, misst jedoch einen LOW-Pegel, kann die Gegenstelle daraus ableiten, dass sich die Schaltvorrichtung (1) in einem Fehlerzustand befindet.**

**Es wird nochmals darauf verwiesen, dass die Ausgangsstufe (3) das Signal (S_EXT) auswertet, um in Abhängigkeit davon das erste massebezogene Signal (S1) auf dem massebezogenen Ausgangssignal (S_OUT) abzubilden oder das massebezogene Ausgangssignal (S_OUT) in einen definierten Zustand, typischerweise auf Massepotential (GND) zu ziehen, während das Signal (S_EXT) von der bidirektionalen Kommunikationsstufe (6) in Kombination mit einer optional daran angeschlossenen Gegenstelle generiert wird.**

**Hierzu gilt noch Folgendes: Die bidirektionale Kommunikationsstufe (6) weist im Gegensatz zum Stand der Technik eine Schnittstelle für das Steuersignal (S_EXT) auf, die sowohl eine Steuerinformation an die Schaltvorrichtung (1) als auch eine Meldeinformation von der Schaltvorrichtung (1) verarbeiten kann.**

**Im Ausführungsbeispiel wird ist daher folgendes bewirkt: Die bidirektionale Kommunikationsstufe (6) verwendet im Anschluss das dritte massebezogene Signal (S3), um über einen Vorwiderstand (64) ein zweites Schaltelement (63), hier als NFET-Transistor ausgeführt, anzusteuern. Der NFET-Transistor bildet hier im Zusammenspiel mit einem zusätzlichen Pull-Up-Widerstand (62), der mit der Versorgungsspannung (VCC) verbunden ist, eine Kommunikationsschnittstelle (61), hier als Open-Drain-Schnittstelle ausgeführt, die in der Lage ist, das Steuersignal (S_EXT) in Abhängigkeit des dritten massebezogenen Signals (S3) auf Massepotential (GND) zu ziehen. Sowohl die bidirektionale Kommunikationsstufe (6) als auch eine optional daran angeschlossene Gegenstelle kann somit das Steuersignal (S_EXT) auf LOW-Pegel ziehen. Steuert weder die bidirektionale Kommunikationsstufe (6) noch die Gegenstelle das Signal (S_EXT) an, so stellt sich durch den Pull-Up-Widerstand (62) auf dem Signal (S_EXT) stets ein HIGH-Pegel ein.**

Die folgende Bezugszeichenliste wird in die Beschreibung einbezogen und erläutert weitere Merkmale der Erfindung.

### Bezugszeichenliste:

- 1: Schaltvorrichtung
- 2: Differenzstufe
- 21: Optokoppler
- 22: Filterelement
- 23: Erstes Schaltelement
- 24: Widerstandsspannungsteiler
- 25: Pull-Down Widerstand
- 26: Vorwiderstand
- 3: Ausgangsstufe
- 31: Viertes Schaltelement
- 32: Viertes Logikgatter
- 33: Vorwiderstand
- 34: Pull-Down-Widerstand
- 35: Fünftes Schaltelement
- 36: Pull-Up-Widerstand
- 4: Weitere Differenzstufe
- 41: Weiterer Optokoppler
- 42: Weiterer Widerstandsspannungsteiler
- 43: Weiterer Pull-Down Widerstand
- 5: Auswertestufe
- 51: Erstes Logikgatter
- 52: Weiteres Filterelement
- 521: RC-Filter
- 522: Zweites Logikgatter
- 53: Speicherelement
- 54: Drittes Logikgatter
- 6: Bidirektionale Kommunikationsstufe
- 61: Kommunikationsschnittstelle
- 62: Pull-Up-Widerstand
- 63: Zweites Schaltelement
- 64: Vorwiderstand
- 7: Versorgungsspannungsschutzstufe
- GND: Massepotential
- t: Zeitdauer
- t1: Erste Signallaufzeit
- t2: Zweite Signallaufzeit
- td: Signallaufzeittoleranzwert
- tf: Verzögerungszeit
- S1: Erstes massebezogenes Signal
- S2: Zweites massebezogenes Signal
- S3: Drittes massebezogenes Signal
- S4: Viertes massebezogenes Signal
- S_DIFF_IN: Differentielles Eingangssignal
- S_EXT: Steuersignal
- S_OUT: Massebezogenes Ausgangssignal
- VCC: Versorgungsspannung
- VCC_EXT: Weitere Versorgungsspannung

## Patentansprüche

1. Schaltvorrichtung (1) zum Wandeln eines differentiellen Eingangssignals (S_DIFF_IN) zu einem massebezogenen Ausgangssignal (S_OUT) mit einem Steuersignal (S_EXT),
**wobei** Fehlerzustände, erkannt werden,
wobei **die Schaltvorrichtung (19) derart geeignet ausgeführt ist, dass** erkannte Fehlerzustände zum Abschalten des massebezogenen Ausgangssignals (S_OUT) führen und zusätzlich auf dem Steuersignal (S_EXT) angezeigt werden,
**dadurch gekennzeichnet, dass**
die Schaltvorrichtung (1) eine Differenzstufe (2) und eine Ausgangsstufe (3) umfasst, wobei die Differenzstufe (2) in Abhängigkeit des differentiellen Eingangssignals (S_DIFF_IN), um eine erste Signallaufzeit t1 verzögert, ein erstes massebezogenes Signal (S1) erzeugt, wobei die Ausgangsstufe (3) das massebezogene Ausgangssignal (S_OUT) in Abhängigkeit des ersten massebezogenen Signals (S1), erzeugt,
**wobei** die Schaltvorrichtung (1) eine weitere Differenzstufe (4), eine Auswertestufe (5) und eine bidirektionale Kommunikationsstufe (6) umfasst,
wobei die weitere Differenzstufe (4) in Abhängigkeit des differentiellen Eingangssignals (S_DIFF_IN) um eine zweite Signallaufzeit t2 verzögert ein zweites massebezogenes Signal (S2) erzeugt,
wobei die Auswertestufe (5) in Abhängigkeit des ersten massebezogenen Signals (S1) und des zweiten massebezogenen Signals (S2) und unter Berücksichtigung der ersten Signallaufzeit t1 und der zweiten Signallaufzeit t2 ein drittes massebezogenes Signal (S3) erzeugt,
wobei die bidirektionale Kommunikationsstufe (6) **derart geeignet ausgeführt ist, dass sie** das Steuersignal (S_EXT)
- **entweder** in Abhängigkeit des dritten Signals (S3)
- **oder** in Abhängigkeit des dritten Signals (S3) **und** zumindest einer Gegenstelle erzeugt,
wobei die Ausgangsstufe (3) **derart geeignet ausgeführt ist, dass sie** das erste massebezogene Signal (S1) zusätzlich in Abhängigkeit des dritten massebezogenen Signals (S3) an das massebezogene Ausgangssignal (S_OUT) weiterleitet.

2. Schaltvorrichtung (1) nach Anspruch 1,
**wobei** die Differenzstufe (2) den Massebezug mittels eines Optokopplers (21) realisiert,
wobei das Ausgangssignal des Optokopplers (21) über ein Filterelement (22) geführt wird, wobei ein erstes Schaltelement (23) in Abhängigkeit des Ausgangssignals des Filterelements (22) eine Versorgungsspannung (VCC) an das erste massebezogene Signal (S1) weiterleitet, wobei sich die erste Signallaufzeit t1 der Differenzstufe (2) aus der Summe der Schaltzeiten des Optokopplers (21) und des ersten Schaltelements (23) und der Verzögerungszeit des Filterelements (22) zusammensetzt.

3. Schaltvorrichtung (1) nach einem der vorangegangenen Ansprüche,
**wobei** die weitere Differenzstufe (4) das zweite massebezogene Signal (S2) mittels eines weiteren Optokopplers (41) realisiert,
wobei die zweite Signallaufzeit t2 der weiteren Differenzstufe (4) größtenteils der Schaltzeit des weiteren Optokopplers (41) entspricht.

4. Schaltvorrichtung (1) nach einem der vorangegangenen Ansprüche,
**wobei** die Auswertestufe (5) das erste massebezogene Signal (S1) und das zweite massebezogene Signal (S2) über zumindest ein erstes Logikgatter (51), insbesondere über ein XOR-Logikgatter, auswertet und das Ausgangssignal des ersten Logikgatters (51) über ein weiteres Filterelement (52) führt,
wobei das weitere Filterelement (52) eine Verzögerungszeit tf aufweist,
wobei die Verzögerungszeit tf in Abhängigkeit von der ersten Signallaufzeit t1, von der zweiten Signallaufzeit t2 und einem Signallaufzeittoleranzwert td gewählt wird, insbesondere wobei die Verzögerungszeit tf = |t2 - t1| + td entspricht.

5. **Schaltvorrichtung (1) nach Anspruch 3,**
**wobei** das weitere Filterelement (52) ein RC-Filter (521) und ein zweites Logikgatter (522), insbesondere ein invertierendes Logikgatter, umfasst,
wobei die Nennwerte des RC-Filters mit tf = R * C gewählt werden,
wobei das zweite Logikgatter (522) das Ausgangssignal des RC-Filters (521) digitalisiert und das Ausgangssignal des weiteren Filterelements (52) erzeugt,
insbesondere wobei das zweite Logikgatters (522) in CMOS-Technologie ausgeführt ist.

6. **Schaltvorrichtung (1) nach Anspruch 3 oder 4,**
**wobei** das Ausgangssignal des weiteren Filterelements (52) dem dritten massebezogenen Signal (S3) entspricht.

7. **Schaltvorrichtung (1) nach Anspruch 3, 4 oder 5,**
**wobei** das Ausgangssignal des weiteren Filterelements (52) ein Speicherelement (53), insbesondere ein RS-FlipFlop, setzt, wobei das Ausgangssignal eines dritten Logikgatters (54), insbesondere eines WIRED-OR-Logikgatters, das Speicherelement (53) rücksetzt, wobei das dritte Logikgatter (54) das erste massebezogene Signal (S1) und das zweite massebezogene Signal (S2) auswertet
und wobei das Ausgangssignal des Speicherelements (53) dem dritten massebezogenen Signal (S3) entspricht.

8. Schaltvorrichtung (1) nach einem der vorangegangenen Ansprüche,
**wobei** die bidirektionale Kommunikationsstufe (6) eine Kommunikationsschnittstelle (61), insbesondere eine Open-Drain-Schnittstelle, mit Pull-Up-Widerstand (62) entweder zur Versorgungsspannung (VCC) oder zu einer weiteren Versorgungsspannung (VCC_EXT) umfasst,
wobei das Steuersignal (S_EXT) über ein zweites Schaltelement (63) in Abhängigkeit des dritten massebezogenen Signals (S3), insbesondere invertierend, nach Massepotential (GND) kurzgeschlossen werden kann.

9. Schaltvorrichtung (1) nach einem der vorangegangenen Ansprüche,
**wobei** die Ausgangsstufe (3) ein viertes Schaltelement (31) und zumindest ein viertes Logikgatter (32), umfasst,
wobei das vierte Schaltelement (31) das erste massebezogene Signal (S1) in Abhängigkeit des dritten massebezogenen Signals (S3) an zumindest einen Versorgungsspannungseingang des vierten Logikgatters (32) weiterleitet,
wobei das vierte Logikgatter (32) das massebezogene Ausgangssignal (S_OUT) in Abhängigkeit des Signals am Versorgungsspannungseingang, insbeosndere und des Steuersignals (S_EXT), erzeugt.

10. Schaltvorrichtung (1) nach einem der vorangegangenen Ansprüche,
**wobei** das Ausgangssignal des Filterelements (22) der Differenzstufe (2) zusätzlich als ein viertes massebezogenes Signal (S4) an die Ausgangsstufe (3) weiterleitet wird,
wobei das vierte Logikgatter (32) der Ausgangsstufe (3) als AND-Logikgatter mit invertierenden Eingängen oder als NOR-Logikgatter ausgeführt ist und das massebezogene Ausgangssignal (S_OUT) zusätzlich in Abhängigkeit des vierten massebezogenen Signals (S4) erzeugt.

11. Schaltvorrichtung (1) nach einem der vorangegangenen Ansprüche,
**wobei** Fehlerzustände, die aus Fehlern auf einer weiteren Versorgungsspannung (VCC_EXT) entstehen, erkannt werden.

12. **Schaltvorrichtung (1) nach Anspruch 7,**
**wobei** die Schaltvorrichtung (1) eine Versorgungsspannungsschutzstufe (7) umfasst, die in Abhängigkeit des Signalpegels der weiteren Versorgungsspannung (VCC_EXT) die Versorgungsspannung (VCC) erzeugt,
wobei der Spannungspegel der weiteren Versorgungsspannung (VCC_EXT) überwacht wird, wobei ein Spannungspegel innerhalb eines gültigen Bereichs, insbesondere innerhalb von +3 ,0 V DC bis +3,5 V DC, zu einer Weiterleitung der weiteren Versorgungsspannung (VCC_EXT) an die Versorgungsspannung (VCC) und ein Spannungspegel außerhalb des gültigen Bereichs zu einer Trennung zwischen der weiteren Versorgungsspannung (VCC_EXT) und der Versorgungsspannung (VCC) führt.

13. System mit der Schaltvorrichtung (1) nach einem der vorangegangenen Ansprüche, aufweisend eine Sicherheits-gerichtete Schaltvorrichtung und einen Frequenzumrichter **dadurch gekennzeichnet, dass**
das differentielle Eingangssignal (S_DIFF_IN) von der Sicherheits-gerichteten Schaltvorrichtung **erzeugt wird,**
**wobei der Frequenzumrichter derart geeignet ausgeführt ist, dass**
- das Steuersignal (S_EXT) vom Frequenzumrichter **ausgewertet und angesteuert wird,**
- **und dass** das massebezogene Ausgangssignal (S_OUT) zur Unterbrechung einer Drehfeld-Erzeugung des Frequenzumrichters **verwendet wird.**

14. System nach Anspruch 13,
**wobei der Frequenzumrichter derart geeignet ausgeführt ist, dass** das Steuersignal (S_EXT) über zumindest ein drittes Schaltelement im Frequenzumrichter nach Massepotential (GND) **kurzgeschlossen wird**
und/oder **wobei der Frequenzumrichter derart geeignet ausgeführt ist, dass** über das massebezogene Ausgangssignal (S_OUT) ein Bustreiber-Baustein zur Übertragung von PWM-Signalen für die Drehfelderzeugung des Frequenzumrichters mit Spannung **versorgt wird.**

## Claims

1. Switching device (1) for converting a differential input signal (S_DIFF_IN) into a ground-referenced output signal (S_OUT) using a control signal (S_EXT),
wherein error states are detected,
wherein the switching device (19) is suitably designed such that detected error states lead to the deactivation of the ground-referenced output signal (S_OUT) and additionally are indicated on the control signal (S_EXT),
**characterized in that**
the switching device (1) includes a differential stage (2) and an output stage (3), wherein the differential stage (2) generates a first ground-referenced signal (S1) as a function of the differential input signal (S_DIFF_IN), delayed by a first signal propagation time t1, wherein the output stage (3) generates the ground-referenced output signal (S_OUT) as a function of the first ground-referenced signal (S1),
wherein the switching device (1) includes a further differential stage (4), an evaluation stage (5) and a bidirectional communications stage (6),
wherein the further differential stage (4) generates a second ground-referenced signal (S2) as a function of the differential input signal (S_DIFF_IN), delayed by a second signal propagation time t2,
wherein the evaluation stage (5) generates a third ground-referenced signal (S3) as a function of the first ground-referenced signal (S1) and the second ground-referenced signal (S2) while taking the first signal propagation time t1 and the second signal propagation time t2 into account,
wherein the bidirectional communications stage (6) is suitably designed such that it generates the control signal (S_EXT)
- either as a function of the third signal (S3)
- or as a function of the third signal (S3) and at least one opposite station,
wherein the output stage (3) is suitably designed such that it forwards the first ground-referenced signal (S1) to the ground-referenced output signal (S_OUT) additionally as a function of the third ground-referenced signal (S3).

2. Switching device (1) according to claim 1,
wherein the differential stage (2) obtains the ground reference by means of an optocoupler (21),
wherein the output signal of the optocoupler (21) is routed via a filter element (22),
wherein a first switching element (23) forwards a supply voltage (VCC) to the first ground-referenced signal (S1) as a function of the output signal of the filter element (22),
wherein the first signal propagation time t1 of the differential stage (2) is composed of the sum of the switching times of the optocoupler (21) and the first switching element (23) and the delay time of the filter element (22).

3. Switching device (1) according to any one of the preceding claims,
wherein the further differential stage (4) obtains the second ground-referenced signal (S2) by means of a further optocoupler (41),
wherein the second signal propagation time t2 of the further differential stage (4) largely corresponds to the switching time of the further optocoupler (41).

4. Switching device (1) according to any one of the preceding claims,
wherein the evaluation stage (5) evaluates the first ground-referenced signal (S1) and the second ground-referenced signal (S2) via at least one first logic gate (51), in particular via an XOR logic gate, and the output signal of the first logic gate (51) is routed via a further filter element (52),
wherein the further filter element (52) has a delay time tf,
wherein the delay time tf is selected as a function of the first signal propagation time t1, the second signal propagation time t2 and a signal propagation time tolerance value td, in particular wherein the delay time tf = |t2-t1|+td.

5. Switching device (1) according to claim 3,
wherein the further filter element (52) includes an RC filter (521) and a second logic gate (522), in particular an inverting logic gate,
wherein the nominal values of the RC filter are selected to be tf = R*C,
wherein the second logic gate (522) digitizes the output signal of the RC filter (521) and generates the output signal of the further filter element (52),
in particular wherein the second logic gate (522) utilizes CMOS technology.

6. Switching device (1) according to claim 3 or 4,
wherein the output signal of the further filter element (52) corresponds to the third ground-referenced signal (S3).

7. Switching device (1) according to claim 3, 4 or 5,
wherein the output signal of the further filter element (52) sets a memory element (53), in particular an RS flip-flop, wherein the output signal of a third logic gate (54), in particular a WIRED-OR logic gate, resets the memory element (53),
wherein the third logic gate (54) evaluates the first ground-referenced signal (S1) and the second ground-referenced signal (S2),
and wherein the output signal of the memory element (53) corresponds to the third ground-referenced signal (S3).

8. Switching device (1) according to any one of the preceding claims,
wherein the bidirectional communications stage (6) has a communications interface (61), in particular an open drain interface, with a pull-up resistor (62) either with respect to the supply voltage (VCC) or with respect to a further supply voltage (VCC_EXT),
wherein the control signal (S_EXT) can be short-circuited to ground potential (GND) via a second switching element (63) as a function of the third ground-referenced signal (S3), in particular in an inverting manner.

9. Switching device (1) according to any one of the preceding claims,
wherein the output stage (3) includes a fourth switching element (31) and at least one fourth logic gate (32),
wherein the fourth switching element (31) forwards the first ground-referenced signal (S1) to at least one supply voltage input of the fourth logic gate (32) as a function of the third ground-referenced signal (S3),
wherein the fourth logic gate (32) generates the ground-referenced output signal (S_OUT) as a function of the signal at the supply voltage input, in particular and the control signal (S_EXT).

10. Switching device (1) according to any one of the preceding claims,
wherein the output signal of the filter element (22) of the differential stage (2) is additionally forwarded as a fourth ground-referenced signal (S4) to the output stage (3),
wherein the fourth logic gate (32) of the output stage (3) is arranged as an AND logic gate with inverting inputs or as a NOR logic gate and generates the ground-referenced output signal (S-OUT) additionally as a function of the fourth ground-referenced signal (S4).

11. Switching device (1) according to any one of the preceding claims,
wherein error states which arise from errors on a further supply voltage (VCC_EXT) are detected.

12. Switching device (1) according to claim 7,
wherein the switching device (1) includes a supply voltage protection stage (7), which generates the supply voltage (VCC) as a function of the signal level of the further supply voltage (VCC_EXT),
wherein the voltage level of the further supply voltage (VCC_EXT) is monitored,
wherein a voltage level within a valid range, in particular within +3.0 V DC to +3.5 V DC, leads to the forwarding of the further supply voltage (VCC_EXT) to the supply voltage (VCC), and a voltage level outside the valid range leads to a separation between the further supply voltage (VCC_EXT) and the supply voltage (VCC).

13. System comprising the switching device (1) according to any one of the preceding claims,
having a safety-directed switching device and a frequency converter,
**characterized in that**
the differential input signal (S_DIFF_IN) is generated by the safety-directed switching device,
wherein the frequency converter is suitably designed such that
- the control signal (S_EXT) is evaluated and actuated by the frequency converter,
- and such that the ground-referenced output signal (S_OUT) is used to interrupt a rotating field generation of the frequency converter.

14. System according to claim 13,
wherein the frequency converter is suitably designed such that the control signal (S_EXT) is short-circuited to ground potential (GND) via at least one third switching element in the frequency converter,
and/or wherein the frequency converter is suitably designed such that a bus driver component is supplied with voltage via the ground-referenced output signal (S_OUT) for the transmission of PWM signals for the rotating field generation of the frequency converter.

## Revendications

1. Dispositif de commutation (1) permettant de convertir un signal d'entrée différentiel (S_DIFF_IN) en un signal de sortie référencé à la masse (S_OUT) avec un signal de commande (S_EXT),
où des états d'erreur sont détectés,
où le dispositif de commutation (19) est mis en oeuvre de manière appropriée pour que des états d'erreur détectés conduisent à la désactivation du signal de sortie référencé à la masse (S_OUT) et soient également indiqués sur le signal de commande (S_EXT),
**caractérisé en ce que**
le dispositif de commutation (1) comprend un étage différentiel (2) et un étage de sortie (3),
où l'étage différentiel (2) produit un premier signal référencé à la masse (S1) en fonction du signal d'entrée différentiel (S_DIFF_IN), retardé d'un premier temps de propagation de signal t1,
où l'étage de sortie (3) produit le signal de sortie référencé à la masse (S_OUT) en fonction du premier signal référencé à la masse (S1),
où le dispositif de commutation (1) comprend un étage différentiel (4) supplémentaire, un étage d'évaluation (5) et un étage de communication bidirectionnel (6),
où l'étage différentiel (4) supplémentaire produit un deuxième signal référencé à la masse (S2) en fonction du signal d'entrée différentiel (S_DIFF_IN), retardé d'un deuxième temps de propagation de signal t2,
où l'étage d'évaluation (5) produit un troisième signal référencé à la masse (S3) en fonction du premier signal référencé à la masse (S1) et du deuxième signal référencé à la masse (S2) et en tenant compte du premier temps de propagation de signal t1 et du deuxième temps de propagation de signal t2,
où l'étage de communication bidirectionnelle (6) est mis en oeuvre de manière appropriée pour produire le signal de commande (S_EXT)
- soit en fonction du troisième signal (S3)
- soit en fonction du troisième signal (S3) et d'au moins un poste correspondant,
où l'étage de sortie (3) est mis en oeuvre de manière appropriée pour transmettre en outre le premier signal référencé à la masse (S1) au signal de sortie référencé à la masse (S_OUT) en fonction du troisième signal référencé à la masse (S3).

2. Dispositif de commutation (1) selon la revendication 1,
où l'étage différentiel (2) réalise la référence de masse au moyen d'un optocoupleur (21),
où le signal de sortie de l'optocoupleur (21) est acheminé par l'intermédiaire d'un élément filtrant (22),
où un premier élément de commutation (23) transmet une tension d'alimentation (VCC) au premier signal référencé à la masse (S1) en fonction du signal de sortie de l'élément filtrant (22),
où le premier temps de propagation de signal t1 de l'étage différentiel (2) est composé de la somme des temps de commutation de l'optocoupleur (21) et du premier élément de commutation (23) et du temps de retard de l'élément filtrant (22).

3. Dispositif de commutation (1) selon l'une quelconque des revendications précédentes,
où l'étage différentiel (4) supplémentaire réalise le deuxième signal référencé à la masse (S2) au moyen d'un optocoupleur (41) supplémentaire,
où le deuxième temps de propagation de signal t2 de l'étage différentiel (4) supplémentaire correspond en grande partie au temps de commutation de l'optocoupleur (41) supplémentaire.

4. Dispositif de commutation (1) selon l'une quelconque des revendications précédentes,
où l'étage d'évaluation (5) évalue le premier signal référencé à la masse (S1) et le deuxième signal référencé à la masse (S2) par l'intermédiaire d'au moins une première porte logique (51), en particulier par l'intermédiaire d'une porte logique XOR, et achemine le signal de sortie de la première porte logique (51) par l'intermédiaire d'un élément filtrant (52) supplémentaire,
où l'élément filtrant (52) supplémentaire présente un temps de retard tf,
où le temps de retard tf est choisi en fonction du premier temps de propagation de signal t1, du deuxième temps de propagation de signal t2 et d'une valeur de tolérance de temps de propagation de signal td,
en particulier où le temps de retard correspond à tf = |t2 - t1| + td.

5. Dispositif de commutation (1) selon la revendication 3,
où l'élément filtrant (52) supplémentaire comprend un filtre RC (521) et une deuxième porte logique (522), en particulier un inverseur logique,
où les valeurs nominales du filtre RC sont choisies de manière à ce que tf = R * C,
où la deuxième porte logique (522) numérise le signal de sortie du filtre RC (521) et génère le signal de sortie de l'élément filtrant (52) supplémentaire,
en particulier où la deuxième porte logique (522) est mise en oeuvre selon la technologie CMOS.

6. Dispositif de commutation (1) selon la revendication 3 ou 4,
où le signal de sortie de l'élément filtrant (52) supplémentaire correspond au troisième signal référencé à la masse (S3).

7. Dispositif de commutation (1) selon la revendication 3, 4 ou 5,
où le signal de sortie de l'élément filtrant (52) supplémentaire définit un élément de mémoire (53), en particulier une bascule RS,
où le signal de sortie d'une troisième porte logique (54), en particulier d'une porte logique WIRED-OR, réinitialise l'élément de mémoire (53),
où la troisième porte logique (54) évalue le premier signal référencé à la masse (S1) et le deuxième signal référencé à la masse (S2)
et où le signal de sortie de l'élément de mémoire (53) correspond au troisième signal référencé à la masse (S3).

8. Dispositif de commutation (1) selon l'une quelconque des revendications précédentes,
où l'étage de communication bidirectionnel (6) comprend une interface de communication (61), en particulier une interface à collecteur ouvert, avec une résistance de tirage (62) par rapport à la tension d'alimentation (VCC) ou par rapport à une tension d'alimentation (VCC_EXT) supplémentaire,
où le signal de commande (S_EXT) peut être court-circuité au potentiel de masse (GND), en particulier avec inversion, par l'intermédiaire d'un deuxième élément de commutation (63) en fonction du troisième signal référencé à la masse (S3).

9. Dispositif de commutation (1) selon l'une quelconque des revendications précédentes,
où l'étage de sortie (3) comprend un quatrième élément de commutation (31) et au moins une quatrième porte logique (32),
où le quatrième élément de commutation (31) transmet le premier signal référencé à la masse (S1) à au moins une entrée de tension d'alimentation de la quatrième porte logique (32) en fonction du troisième signal référencé à la masse (S3),
où la quatrième porte logique (32) génère le signal de sortie référencé à la masse (S_OUT) en fonction du signal à l'entrée de tension d'alimentation, et en particulier du signal de commande (S_EXT).

10. Dispositif de commutation (1) selon l'une quelconque des revendications précédentes,
où le signal de sortie de l'élément filtrant (22) de l'étage différentiel (2) est en outre transmis à l'étage de sortie (3) sous la forme d'un quatrième signal référencé à la masse (S4),
où la quatrième porte logique (32) de l'étage de sortie (3) est mise en oeuvre sous la forme d'une porte logique AND munie d'entrées inversantes ou sous la forme d'une porte logique NOR et le signal de sortie référencé à la masse (S_OUT) est en outre généré en fonction du quatrième signal référencé à la masse (S4).

11. Dispositif de commutation (1) selon l'une quelconque des revendications précédentes,
où des états d'erreur résultant d'erreurs sur une tension d'alimentation (VCC_EXT) supplémentaire sont détectés.

12. Dispositif de commutation (1) selon la revendication 7,
où le dispositif de commutation (1) comprend un étage de protection de tension d'alimentation (7) qui génère la tension d'alimentation (VCC) en fonction du niveau de signal de la tension d'alimentation (VCC_EXT) supplémentaire,
où le niveau de tension de la tension d'alimentation (VCC_EXT) supplémentaire est surveillé,
où un niveau de tension dans une plage valide, en particulier dans une plage comprise entre +3,0 V CC à +3,5 V CC, entraine la transmission de la tension d'alimentation (VCC_EXT) supplémentaire à la tension d'alimentation (VCC) et un niveau de tension en dehors de la plage valide entraine une coupure entre la tension d'alimentation (VCC_EXT) supplémentaire et la tension d'alimentation (VCC).

13. Système comprenant le dispositif de commutation (1) selon l'une quelconque des revendications précédentes, présentant un dispositif de commutation de sécurité et un convertisseur de fréquence, **caractérisé en ce que**
le signal d'entrée différentiel (S_DIFF_IN) est généré par le dispositif de commutation de sécurité,
où le convertisseur de fréquence est mis en oeuvre de manière appropriée pour que
- le signal de commande (S_EXT) soit évalué et commandé par le convertisseur de fréquence
et pour que le signal de sortie référencé à la masse (S_OUT) soit utilisé pour interrompre la génération d'un champ tournant du convertisseur de fréquence.

14. Système selon la revendication 13,
où le convertisseur de fréquence est mis en oeuvre de manière appropriée pour que le signal de commande (S_EXT) soit court-circuité au potentiel de masse (GND) par l'intermédiaire d'au moins un troisième élément de commutation dans le convertisseur de fréquence
et/ou où le convertisseur de fréquence est mis en oeuvre de manière appropriée pour qu'un module de pilote de bus permettant la transmission de signaux MLI destinés à la production de champ tournant du convertisseur de fréquence soit alimenté en tension par l'intermédiaire du signal de sortie référencé à la masse (S_OUT).
